(19) Europäisches Patentamt

European Patent Office

Office européen des brevets

(11) **EP 1 817 799 B1**

(12) **EUROPÄISCHE PATENTSCHRIFT**

(45) Veröffentlichungstag und Bekanntmachung des Hinweises auf die Patenterteilung:
**05.04.2017  Patentblatt 2017/14**

(21) Anmeldenummer: **05801639.5**

(22) Anmeldetag: **11.10.2005**

(51) Int Cl.:
*H01L 29/872* <sup>(2006.01)</sup>     *H01L 27/08* <sup>(2006.01)</sup>
*H01L 25/07* <sup>(2006.01)</sup>     *H02P 9/48* <sup>(2006.01)</sup>

(86) Internationale Anmeldenummer:
**PCT/EP2005/055164**

(87) Internationale Veröffentlichungsnummer:
**WO 2006/056505 (01.06.2006 Gazette 2006/22)**

(54) **HALBLEITERBAUELEMENT UND GLEICHRICHTERANORDNUNG**

SEMICONDUCTOR DEVICE AND RECTIFIER ARRANGEMENT

DISPOSITIF A SEMI-CONDUCTEURS ET ENSEMBLE REDRESSEUR

(84) Benannte Vertragsstaaten:
**DE FR IT SK**

(30) Priorität: **24.11.2004   DE 102004056663**

(43) Veröffentlichungstag der Anmeldung:
**15.08.2007   Patentblatt 2007/33**

(73) Patentinhaber: **ROBERT BOSCH GMBH**
**70442 Stuttgart (DE)**

(72) Erfinder:
• **SPITZ, Richard**
  **72766 Reutlingen (DE)**

• **GOERLACH, Alfred**
  **72127 Kusterdingen (DE)**
• **WOLF, Gert**
  **71563 Affalterbach (DE)**
• **MUELLER, Markus**
  **74078 Heilbronn (DE)**

(56) Entgegenhaltungen:
EP-A- 1 411 551      WO-A-95/02258
DE-A1- 19 545 234    US-A- 4 142 893
US-A- 5 262 669      US-A- 5 371 400

EP 1 817 799 B1

**Beschreibung**

Stand der Technik

Die Erfindung betrifft eine Halbleitereinrichtung nach dem Oberbegriff des Anspruchs 1 sowie eine Gleichrichteranordnung mit einer solchen Halbleitereinrichtung.

Zur Gleichrichtung werden bei Drehstromgeneratoren bzw. Lichtmaschinen Wechselstrombrücken bzw. Gleichrichter verwendet. Im Regelfall setzen sich die Gleichrichter aus 6 Halbleiterdioden mit einem pn-Übergang aus Silizium zusammen. Diese Dioden sind für den Betrieb bei hohen Strömen (z.B. Stromdichte bis 500A/cm$^2$) und hohen Temperaturen (z.B. Sperrschichttemperatur Tj < 225°C) ausgelegt. Typischerweise beträgt der Spannungsabfall in Flussrichtung, die Flussspannung UF, bei den verwendeten hohen Strömen ca. 1 Volt. Bei Betrieb in Sperrrichtung fließt i.a. nur ein sehr kleiner Sperrstrom IR bis zu einer Durchbruchsspannung UZ. Ab dieser Spannung steigt der Sperrstrom sehr stark an. Ein weitere Spannungsanstieg wird deshalb verhindert.

Man unterscheidet zwischen hochsperrenden Dioden (HS-Dioden) mit UZ etwa im Bereich zwischen 200 und 400 Volt und Z-Dioden mit Sperrspannungen - je nach Bordnetzspannung des Kfz's - von ca. 20 - 40 Volt. Die hochsperrenden Dioden (HS-Dioden) dürfen nicht im Durchbruch betrieben werden. Z-Dioden können auch im Durchbruch, kurzzeitig sogar mit sehr hohen Strömen, belastet werden. Sie werden deshalb zur Begrenzung der überschießenden Generatorspannung bei Lastwechseln bzw. im Loaddump-Fall eingesetzt.

Ein gewisser Nachteil ist die Flussspannung der pn-Dioden, die zu Durchlassverlusten und damit zur Wirkungsgradverschlechterung des Generators führt. Da im Mittel immer zwei Dioden in Reihe geschaltet sind, betragen die mittleren Durchlassverluste bei einem 100A Generator ca. 200W. Die damit verbundene Aufheizung von Dioden und Gleichrichter muss durch aufwendige Kühlmaßnahmen (Kühlkörper, Lüfter) verringert werden.

Zur Reduktion der Durchlassverluste wird immer wieder vorgeschlagen, sogenannte Schottky-Dioden (Schottky Barrier Diode, SBD) an stelle von pn-Dioden einzusetzen. Schottky-Dioden sind Metall-Halbleiterübergänge, die eine den pn-Dioden ähnliche elektrische Kennlinie aufweisen. Im Gegensatz zu pn-Dioden kann bei Schottky-Dioden die Flussspannung durch die Wahl des Metalls in gewissen Grenzen frei gewählt und vor allem kleiner eingestellt werden als bei pn-Dioden. So können z.B. Flussspannungen UF von 0,5-0,6V ohne Schwierigkeit realisiert werden. Mit der Wahl des Metalls wird im wesentlichen die sogenannte (Energie-) Barrierenhöhe PhiBn definiert. Nur Elektronen, die diese Barriere überwinden können tragen zum Stromfluss bei. Die Barrierenhöhe kann durch geeignete Wahl des "Barrierenmetalls" beeinflusst werden. Außerdem hängt die Barrierenhöhe PhiBn auch noch vom verwendeten Halbleiter ab (Halbleitermaterial: kovalenter oder ionischer Halbleiter, n- oder p-Dotierung, usw.).

Der Zusammenhang zwischen Vorwärtsstromdichte jF und Sperrstromdichte jR wird durch folgende Beziehung beschrieben (siehe z. B. Textbuch "Power Semiconductor Devices" von B.J.Baliga, PWS Publishing Company, Boston, 1996):

$$jR = jF \cdot \exp(\frac{-q \cdot UF}{k \cdot Tj}) \qquad (1)$$

Dabei bezeichnet q die elektrische Elementarladung und k die Boltzmannkonstante. Tj ist die Sperrrrschichttemperatur (Junctiontemperatur) der Diode in Kelvin. Man erkennt, dass die Sperrströme bei klein gewählter Flussspannung hoch sind. Jedoch kann durch geeignete Wahl von UF der Sperrstrom für die Anwendung im Generator ausreichend klein gewählt werden. (Trade-off zwischen Flussspannung und Sperrstrom.)

Obige Beziehung (1) beschreibt allerdings nur den Grenzfall einer idealen Schottky-Diode. Neben technologisch begründeten Mängeln wird durch diese Beziehung insbesondere die Abhängigkeit des Sperrstromes von der Sperrspannung nicht beschrieben. Diese Abhängigkeit lässt den Sperrstrom mit zunehmender Sperrspannung weit über die durch die Beziehung 1 beschrieben Stromwerte ansteigen. Ursache dafür ist eine Abnahme der Barrierenhöhe PhiBn mit zunehmender Sperrspannung. Dieser Zusammenhang wird auch als Bildkrafteffekt bzw. als Schottky-Effekt oder auch als Barrier Lowering Effekt (BL) bezeichnet. Die von den Sperrströmen bei konventionellen Schottky-Dioden erzeugten Sperrverluste sind, insbesondere bei den im Generatoreinsatz vorkommenden hohen Temperaturen, im Allgemeinen so hoch, dass das System thermisch instabil wird.

Grundsätzlich lassen sich Schottky-Dioden auch im Sperrspannungsdurchbruch betreiben, d.h. ein Betrieb als Z-Diode ist möglich. Da sich der Schottky-Kontakt an der Oberfläche des Halbleiters befindet, ist er gegenüber Kristallstörungen und Verschmutzungen etwas anfällig. Deshalb ist die Zuverlässigkeit beim Z-Betrieb häufig eingeschränkt und wird im Allgemeinen. nicht zugelassen.

Bei der Halbleitereinrichtung der gattungsgemäßen Art handelt es sich um eine Kombination einer herkömmlichen Schottky-Diode mit einer weiteren Halbleiterstruktur, die in Trench-Technik ausgeführt sind und über eine Grabenstruktur verfügen. Die Halbleitereinrichtung eignet sich auch gut als Zenerdiode und ist für den Einsatz in einem Gleichrichter für einen Generator in einem Kraftfahrzeug einsetzbar.

Aus der DE 694 28 996 T2 sind bereits Halbleitereinrichtungen bekannt, mit Strukturen, die eine Kombination von herkömmlichen Schottky-Dioden (SPD) mit einer weiteren Halbleiterstruktur, nämlich einer Feldplatte, in Trench-Struktur umfassen. Die Struktur setzt sich aus einer Vielzahl von Zellen zusammen. Diese Art von Schottky-Dioden wird auch als Trench-MOS-Barrier-Schottky-Diode (TMBS) genannt. Auch aus der DE 195 45 234 A1 ist bereits eine Schottky-Diode zur Verwendung in einem Gleichrichter bekannt.

Vorteile der Erfindung

Die erfindungsgemäße Halbleitereinrichtung hat den Vorteil, dass sie einerseits sehr robust ist und andererseits einen sehr niedrigen Sperrstrom aufweist. Erzielt wird dieser Vorteil, indem die Halbleitereinrichtung als Hocheffizienz-Schottky-Diode (HED) ausgestaltet ist und keinen "Barrier-Lowering-Effect" (BL) aufweist. Dadurch wird der niedrige Sperrstrom gewährleistet.

Besonders vorteilhaft ist der Verlauf der Gesamtverlustleistung der erfindungsgemäßen Halbleitereinrichtung, der sich gegenüber herkömmlichen Schottky-Dioden dadurch auszeichnet, dass bei höheren Temperaturen die Verlustleistung wesentlich weniger stark ansteigt und insbesondere bis zu höheren Temperaturen als bei herkömmlichen Schottky-Dioden sogar absinkt.

Weitere Vorteile der Erfindung werden durch die in den Unteransprüchen angegebenen Maßnahmen erzielt. Besonders vorteilhaft lassen sich solche Halbleitereinrichtungen in Gleichrichteranordnungen einbauen, die für hohe Leistungen geeignet sein sollen und bestimmte Temperaturen nicht überschreiten dürfen. Solche Gleichrichter sind beispielsweise Gleichrichter für Drehstromgeneratoren in Kraftfahrzeugen, bei denen jeweils sechs erfindungsgemäße Halbleitereinrichtungen eingesetzt werden. Durch die geringe Verlustleistung lassen sich besonders einfache Ausgestaltungen der Anordnung der Halbleitereinrichtungen durchführen.

In vorteilhaften Ausgestaltungen kann der Kühlkörper, der beim Einsatz herkömmlicher Gleichrichter benötigt wird, entfallen.

Es wird vorgeschlagen an Stelle von konventionellen Schottky-Dioden, einen neue Art von Schottky Dioden - in dieser Erfindung als Hocheffizienz-Schottky-Dioden (HED) bezeichnet - in Gleichrichtern für Generatoren einzusetzen. Diese Dioden können bei höheren Sperrschichttemperaturen Tj betrieben werden als übliche Schottky-Dioden und eignen sich deshalb erstmals zum Betrieb in Generatoren. Durch die geringen Durchlassverluste erhöht sich der Wirkungsgrad und die Abgabeleistung des Generators.

Durch das schnelle Schalten der Schottky-Dioden verbessert sich zudem die Rundfunkentstörung des Generators in bestimmten Frequenzbereichen um bis zu 10dB.

In Folge der niedrigeren Sperrverlustleistungen kann der Aufwand für die Kühlung der Dioden gegenüber dem Einsatz von pn-Dioden reduziert werden. Außerdem erhöhen die geringeren Temperaturen der Dioden den Freiheitsgrad für die Auslegung des Gleichrichters (Partitionierung). Zumindest bei einigen Varianten von HED ist sogar der Zener-Betrieb (Z-Betrieb) möglich. Als Hocheffizienz-Schottky-Dioden HED werden Dioden bezeichnet, die keinen Barrier Lowering Effekt (BL) mehr aufweisen und somit niedrigere Sperrströme haben. Für HED kann deshalb die Beziehung 1 angewendet werden. Die Gesamtverlustleistung setzt sich aus Durchlass- und Sperrverlusten zusammen. Allgemein gilt für die Gesamtverlustleistung P:

$$P = 0{,}5 \cdot UF \cdot IF + 0{,}5 \cdot IR \cdot UR \qquad (2)$$

Mit Flussspannung UF, Flussstrom IF, Sperrstrom IR und Sperrspannung UR. Die Abhängigkeit von Sperrstrom und Flussspannung von der Temperatur ist ebenfalls in oben erwähntem Textbuch beschrieben. Dort ist auch ein Ausdruck für den Einfluss der Sperrspannung auf den Sperrstrom (BL) angegeben. Mit diesen, dem Fachmann bekannten Beziehungen, kann mit Hilfe von Gleichung 2 die Verlustleistung einer üblichen Schottky-Diode (mit BL-Effekt) mit der Verlustleistung einer HED (ohne BL-Effekt) verglichen werden.

Zeichnung

Ausführungsbeispiele der Erfindung sind in der Zeichnung dargestellt und werden in der nachfolgenden Beschreibung näher erläutert. Im Einzelnen zeigen:

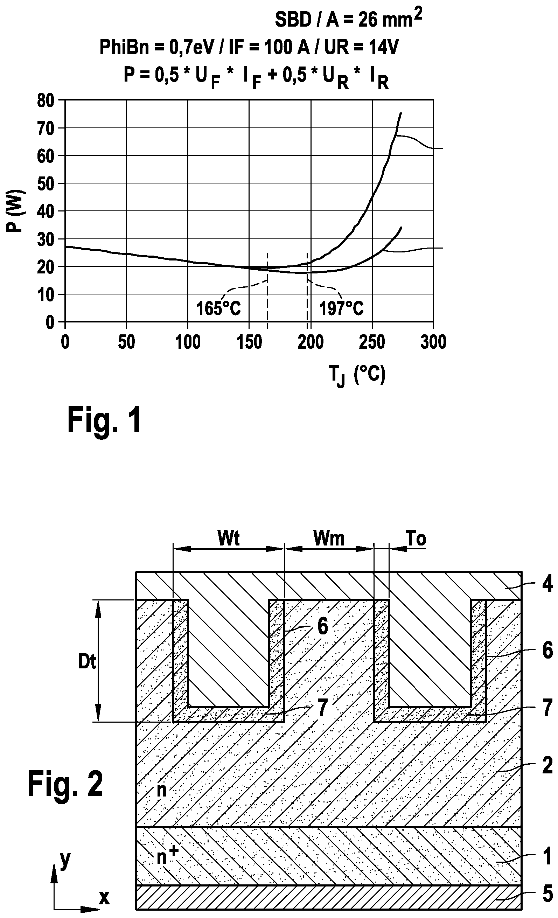

Figur 1 den Verlauf der Gesamtverlustleistung über der Sperrschichttemperatur für herkömmliche Schottky-Dioden und erfindungsgemäße Halbleitereinrichtungen bzw. TMBS-Dioden und Figur 2 zeigt den Querschnitt (Ausschnitt) einer TMBS-Diode.

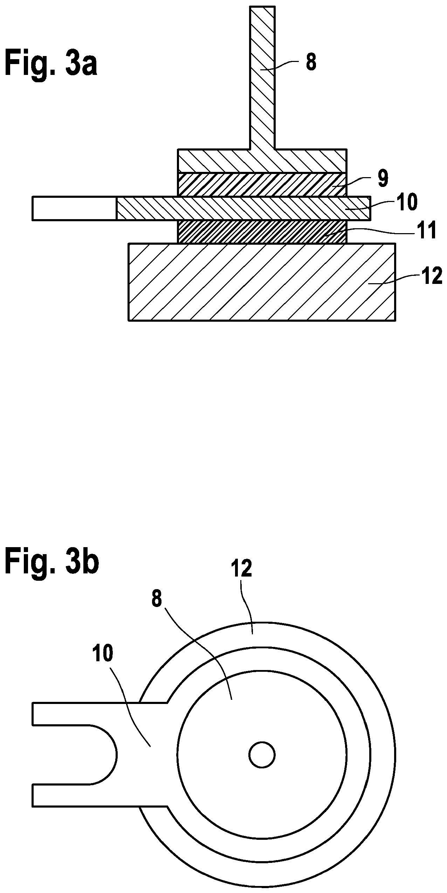

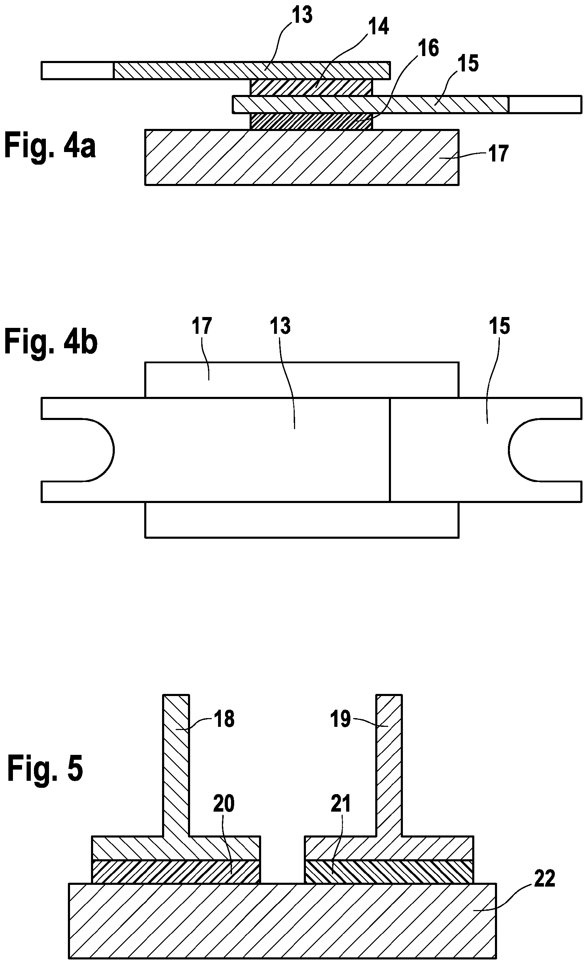

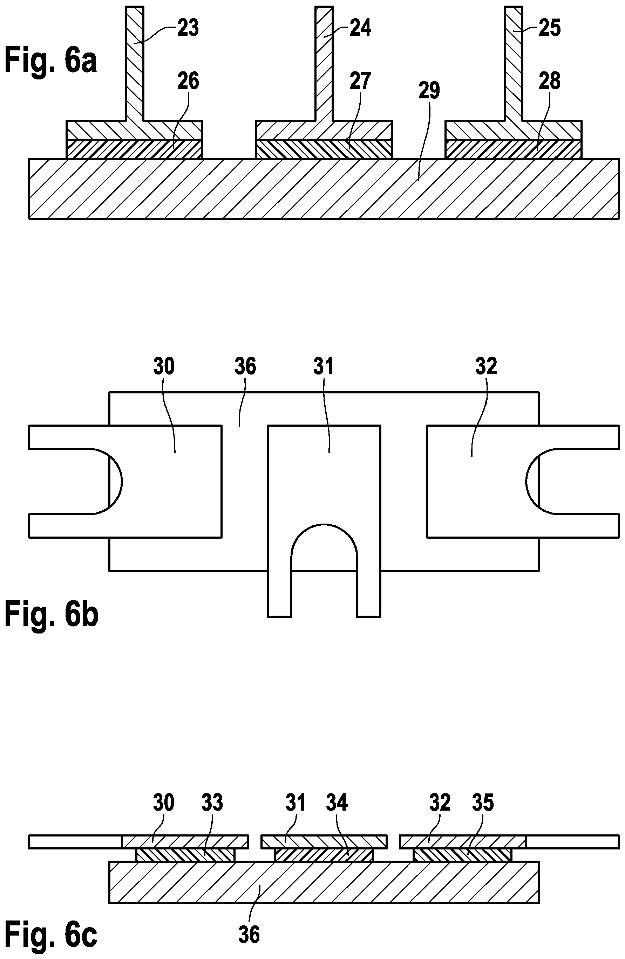

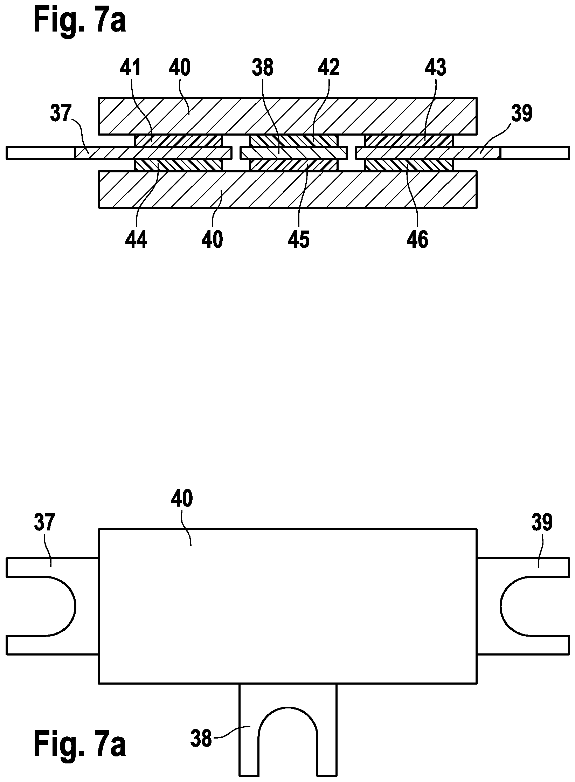

In Figur 3 ist ein Gleichrichter mit zwei Chips in einer Verpackung in Seitenschnitt bzw. in der Draufsicht dargestellt und Figur 4 zeigt die Ausführung einer Lötdiode im Seitenschnitt bzw. in der Draufsicht. Figur 5 zeigt die Partitionierung von zwei Plus- oder Minuschips in einem Gehäuse und die Figuren 6 und 7 die Partitionierung von drei Chips bzw. sechs Chips, insbesondere in einem Gehäuse.

Beschreibung

In Figur 1 ist der Vergleich der Gesamtverlustleistung einer herkömmlichen Schottky-Diode mit einer Hocheffizienz-Schottky-Diode HED als Funktion von der Temperatur aufgetragen. Dabei ist der Einfluss des BL auf die Gesamtverlustleistung einer Schottky-Diode für den Fall einer Barrierenhöhe PhiBn = 0,7eV und einer Chipfläche A = 26mm$^2$ angegeben. In dem Beispiel beträgt der Vorwärtsstrom IF=100A und die Sperrspannung UR=14V. Die obere Kurve entspricht der herkömmlichen Schottky-Diode mit Barrier-Lowering und die untere Kurve entspricht der Hocheffizienz-Schottky-Diode ohne Barrier-Lowering.

Die geringe Verlustleistung von ca. 25 Watt der Diode nimmt mit zunehmender Temperatur wegen des negativen Temperaturkoeffizienten der Flussspannung einer Schottky-Diode - wie im Fall einer pn-Diode - zunächst ab. Im Fall der pn-Diode ergäbe sich allerdings etwa die doppelte Verlustleistung. Bei höheren Temperaturen steigt die Gesamtverlustleistung wegen des positiven Temperaturkoeffizienten des Sperrstroms dagegen an. Die maximal zulässige Junction-Temperatur $T_J$ wird durch den Wendepunkt des Temperaturverlaufs der Gesamtverlustleistung bestimmt. Im dargestellten Beispiel kann durch den Einsatz einer Hocheffizienz-Schottky-Diode die maximal zulässige Sperrschichttemperatur $T_J$ von 165° auf 197° angehoben werden. Damit wird ein Einsatz solcher Dioden in Gleichrichtern für Generatoren, bei denen Temperaturen über 165° auftreten können, jedoch unter 197° bleiben, möglich.

In Figur 2 ist ein Beispiel für eine Hocheffizienz-Schottky-Dioden angegeben, wobei der Querschnitt einer Trench-MOS-Barrier-Schottky-Diode TMBS in einem Ausschnitt dargestellt. Solche Hocheffizienz-Schottky-Dioden bestehen aus einer monolithisch auf einem Halbleiterchip integrierten Kombination von herkömmlicher Schottky-Diode (SBD) mit anderen Elementen wie Feldplatten, pn-Übergängen oder unterschiedlichen Barrier-Metallen. Sie sind in Trench-Technik ausgeführt, d.h. die HED enthält mindestens einige Graben- oder Trench-Strukturen. Die Gräben sind dabei typischerweise etwa 1-3 $\mu$m tief und ca. 0,5 bis 1 $\mu$m breit. Der Abstand der Gräben liegt im Bereich von 0,5 bis 1 $\mu$m. In Figur 2 werden zwei solche Zellen dargestellt, die Diode selbst enthält jedoch eine Vielzahl solcher Zellen. Die dargestellte Art von Schottky-Dioden wird im Folgenden als Trench-MOS-Barrier-Schottky-Diode TMBS bezeichnet.

Die TMBS-Diode besteht aus einem n$^+$-Substrat 1, einer n-Epischicht 2, mindestens zwei in der n-Epischicht 2 durch Ätzen realisierten Gräben (Trenchs) 6, Metallschichten an der Vorderseite des Chips 4 als Anodenelektrode und an der Rückseite des Chips 5 als Kathodenelektrode und einer Oxidschicht 7 zwischen den Gräben 6 und der Metallschicht 4. Elektrisch gesehen ist die TMBS eine Kombination von MOS-Struktur (Metallschicht 4, Oxidschicht 7 und n-Epischicht 2) und einer Schottky-Diode (Schottky-Barriere zwischen der Metallschicht 4 als Anode und der n-Epischicht 2 als Kathode). In der Flussrichtung fließen Ströme durch den Mesa-Bereich zwischen den Gräben 6. Die Gräben 6 selber stehen für den Stromfluss nicht zur Verfügung.

Der Vorteil einer TMBS liegt in der Reduktion der Sperrströme. In der Sperrrichtung bilden sich sowohl bei der MOS-Struktur als auch bei der Schottky-Diode Raumladungszonen aus. Die Raumladungszonen dehnen sich mit steigender Spannung aus und stoßen bei einer Spannung die kleiner als die Durchbruchspannung der TMBS ist, in der Mitte des Bereichs zwischen den benachbarten Gräben 6, zusammen. Dadurch werden die für die hohen Sperrströme verantwortlichen Schottky-Effekte abgeschirmt und die Sperrströme reduziert. Dieser Abschirmeffekt ist stark von Strukturparametern $Dt$ (Tiefe des Grabens), $Wm$ (Abstand zwischen den Gräben), $Wt$ (Breite des Grabens) sowie von To (Dicke der Oxidschicht) abhängig, siehe Fig.2.

Weitere Vorschläge für HED-Strukturen sind z.B. die Kombination von Schottky-Dioden mit pn-Dioden im Trench usw.. Allgemein sollen alle Kombinationen von Schottky-Dioden mit Feldplatten, wie beim TMBS, mit pn-Dioden wie bei TJBS und andere Bauelemente mit Schottky-Dioden als Hocheffizienzdioden HED bezeichnet werden, sofern sie wenigstens einen Trench bzw. Graben aufweisen.

Die bisher bekannten Kombinationsbauelemente mit Trenchstrukturen sind vor allem für sehr niedrige Flussspannungen UF ausgelegt, z.B. UF= 0,4V. Anwendungsgebiete sind z.B. unterbrechungsfreie Stromversorgungen, die eine sehr kleine Flussspannung UF erfordern, aber nicht bei hohen Temperaturen betrieben werden müssen. Die Einstellung der Flussspannung erfolgt durch Wahl eines Metalls mit entsprechend (kleiner) Barrierenhöhe PhiBn. Als Folge davon ist IR relativ hoch und max. zulässige Einsatztemperatur gering. Diese Strukturen sind für die Anwendung in Generatoren nicht geeignet.

Bei einer Hocheffizienz-Schottky-Diode für Generatorapplikation wird die Barrierenhöhe so ausgelegt, dass eine etwas höhere Durchlassspannungen UF, z.B. UF=0,5-0,6V, aber gleichzeitig geringere Sperrströmen auftreten. Vorzugsweise werden Barrierenhöhen von ca. 0,65-0,75 eV gewählt.

Eine Anordnung wie in Fig.2 gezeigt, kann i.a. nicht zuverlässig im Sperrspannungsdurchbruch betrieben werden.

Beim Durchbruch entstehen sehr hohe elektrische Felder innerhalb der Oxidschicht 7 und direkt in der Nähe der Oxidschicht in der n-Epischicht 2. Die Sperrströme fließen hauptsächlich durch eine Quasi-Inversionsschicht der MOS-Struktur entlang der Grabenoberfläche. Als Folge kann die MOS-Struktur durch Injektion "heißer" Ladungsträger von der n-Epischicht 2 in die Oxidschicht 7 degradiert und unter bestimmten Betriebsbedingungen sogar zerstört werden. Falls die Spannungsbegrenzung im Loaddumpfall trotzdem gewünscht wird, können im Gleichrichter auch herkömmliche Z-Dioden zu den HED parallel geschaltet werden. In diesem Fall muss die Durchbruchsspannung der HED größer gewählt werden als bei der Z-Diode. Dann übernehmen die HED in Vorwärtsrichtung den Strom, während der Durchbruch ausschließlich in der Z-Diode stattfindet. Außerdem sind Strukturen denkbar, die z.B. (zusätzlich) einen pn-Übergang integriert haben, der die Durchbruchsspannung bestimmt. Solche HED sind sogar direkt als Z-Dioden einsetzbar.

Der Einsatz von Hocheffizienz-Schottky-Dioden erlaubt es, infolge der geringen Verlustleistung der Dioden bei ihrem Einsatz in einen Gleichrichter die Kühlfläche deutlich zu reduzieren. Es ist dadurch möglich, auf einen Kühlkörper ganz zu verzichten bzw. die Plus- und Minuskühlkörper gegenüber herkömmlichen Gleichrichtern deutlich zu verkleinern. Hierdurch ergeben sich neue Partitionierungsmöglichkeiten, die beim Einsatz herkömmlicher Dioden an zu hohen Bauteiltemperaturen gescheitert sind. Möglichkeiten für solche Partitionierungen werden in den folgenden Figuren verdeutlicht. Es gilt dabei der Zusammenhang: Geringere Leistung ergibt geringere Temperatur und ermöglicht daher andere Partitionierung der Gleichrichter als bisher.

In Figur 3 ist eine erste Möglichkeit einer erfindungsgemäßen Anordnung von zwei Diodenchips zur Bildung eines Gleichrichters in einer Verpackung angegeben. Dabei ist die Partitionierung so gewählt, dass sowohl Plus- als auch Minusdiode in einem Gehäuse angeordnet ist und die Diode selbst als Einpressdiode ausgestaltet ist. Eine solche Gleichrichteranordnung für einen Generator in einem KFZ ist aus Temperaturgründen nur möglich, da die Verlustwärme bei HED Elementn geringer ist als bei herkömmlichen Dioden.

Im Einzelnen zeigt Figur 3a einen Seitenquerschnitt und Figur 3b eine Draufsicht. Die Gesamtanordnung setzt sich dabei zusammen aus einem Kopfdraht 8, einem Pluschip 9, einem Ständeranschluss 10, einem Minuschip 11 sowie dem Diodensockel 12. Der Diodensockel 12 ist als Einpressdiodensockel ausgestaltet und ist vorzugsweise ein Sockel mit Massepotenzial und beispielsweise in das B-Lagerschild des Generators eingepresst. Die Einbindung ist beispielsweise mit Schlaufen oder U-förmigen Ausprägungen am Ständeranschluss versehen, dies dient zur einfacheren Befestigung der Anschlussdrähte. Ein separater Kopfdraht für den Anschluss der Ständerdrähte ist möglich.

Figur 4 zeigt eine Ausführung als Lötdiode, wobei Figur 4a wiederum den Seitenschnitt und Figur 4b die Draufsicht zeigt. Im Einzelnen zeigen die Anordnungen den Plusanschluss 13, den Pluschip 14, den Ständeranschluss 15, den Minuschip 16 und den Diodensockel 17, wobei der Diodensockel als Lötsockel ausgestaltet ist und vorzugsweise ein Sockel mit Massepotenzial darstellt, der beispielsweise an einem Kühlkörper angelötet wird. Vorzugsweise sind Schlaufen oder U-förmige Ausprägungen am Ständeranschluss und beim Plusanschluss vorgesehen, zur einfacheren Befestigung der Anschlussdrähte. Ein separater Kopfdraht ist ebenfalls möglich. Weitere Ausgestaltungen sind derart, dass der Pluspotenzialanschluss vergleichbar zu einer Button-CAN-Diode auch gelötet wird.

In Figur 5 ist die Partitionierung von zwei Plus- oder Minuschips in einem Gehäuse dargestellt. Es sind dabei zwei Kopfdrähte 18, 19, zwei Chips 20, 21 sowie ein gemeinsamer Diodensockel 22 vorgesehen. Beim Diodensockel handelt es sich um einen Löt- oder Einpresssockel. Zwei Chips werden in einem Gehäuse verbaut. Dazu sind zwei Anschlussdrähte vorhanden und der Sockel hat jeweils Plus- oder Minuspolarität. Die Ständeranschlüsse werden beispielsweise über eine Verschaltungsplatte mit den Kopfdrähten verbunden.

Figur 6 a bis c zeigt Partitionierungsmöglichkeiten von drei Chips. Dabei sind drei Kopfdrähte 23, 24, 25, 3 Chips 26, 27, 28 sowie ein gemeinsamer Diodensockel 29 vorhanden. Alternativ dazu sind drei Ständeranschlussteile 30, 31, 32, drei Chips 33, 34, 35 sowie ein Diodensockel 36 vorhanden. Die Ständeranschlussteile 30, 31, 32 sind vorzugsweise so ausgerichtet, dass das mittlere, um 90° gegenüber den beiden anderen gedreht ist.

Als Sockel wird ein Löt- oder Einpresssockel verwendet. Die drei Chips werden in einem Gehäuse verbaut, das drei Anschlussdrähte aufweist. Der Sockel hat jeweils Plus- oder Minuspolarität. Die Ständeranschlüsse werden über die Verschaltungsplatte mit den Kurzdrähten verbunden oder in einem anderen Ausführungsbeispiel durch Schlaufen oder U-förmige Ausprägungen, die vorzugsweise mit den U-förmigen Ausprägungen des anderen Halbgleichrichters ineinander greifen und so eine gemeinsame Fixierung der Ständeranschlussdrähte bilden.

In Figur 7 ist ein Ausführungsbeispiel mit einer Partitionierung von 6 Chips in einem Gehäuse dargestellt. Auch bei dieser Anordnung sind drei Ständeranschlussteile 37, 38, 39 für je einen Diodensockel 40 vorgesehen. Zwischen dem Ständeranschlussteil und dem Diodensockel befinden sich jeweils 3 Chips. Diese Anordnung wird doppelt gewählt, so dass sich auf dem Löt- oder Einpresssockel eine Anordnung mit sechs Chips 41 bis 46 ergibt, die in einem gemeinsamen Gehäuse verbaut werden. Drei Anschlüsse für den Ständerdraht ermöglichen den Anschluss der entsprechenden Ständerwicklungen. Der Sockel hat jeweils Plus- oder Minuspolarität. Die Ständeranschlüsse werden wiederum durch Schlaufen oder U-förmige Ausprägungen hergestellt. Eine Direktmontage aller Dioden auf dem B-seitigen Lagerschild oder einem separaten Kühlkörper ist möglich.

Eine weitere Ausführungsform, die nicht in einer Figur dargestellt ist, weist HED und Standard Zener- bzw. Z-Dioden auf, die zueinander bezogen auf den Load-Dump-Fall parallel liegen. Um den Load-Dump-Schutz des HED-Gleichrichters zu erhöhen, wird dabei eine Z-Diode parallel B+ B- geschaltet, drei Z.Dioden parallel der Plus- oder Minusdioden geschaltet oder zwei Dioden parallel zu jeder Plus- und jeder Minusdiode jedes Zweiges geschaltet. Bei einer weiteren Ausgestaltung wird die Partitionierung derart vorgenommen, dass HED- und HS- oder Zehnerdioden parallel bezogen auf die Temperaturfestigkeit liegen. Um eine Überlastung der HED-Diode infolge des positiven Verlustgradienten im Bereich von über 197°C zu verhindern, werden den heißesten HED-Dioden Dioden mit höherer Temperaturfestigkeit parallel geschaltet. Hierdurch stabilisiert sich die anfallende Verlustleistung spätestens bei Erreichen der Verlustleistung der temperaturfesten Dioden.

**Patentansprüche**

1. Gleichrichteranordnung für einen Generator in einem Fahrzeug, mit einer Halbleitereinrichtung, umfassend eine Hocheffizienz-Schottky-Diode HED mit einem Halbleiterchip, der Graben- oder Trench-Strukturen aufweist, mit einer monolithisch im Halbleiterchip integrierten Kombination aus wenigstens einer Schottky-Diode mit einem weiteren Halbleiterelement, wobei das weitere Halbleiterelement als pn-Diode im Trench oder als MOS-Struktur im Trench ausgestaltet ist, **dadurch gekennzeichnet, dass** die Einstellung der Durchlassspannung (UF) durch Wahl eines Barrierenmetalls, das die Barrierenhöhe (PhiBn) für eine Schottky-Barriere definiert, so erfolgt, dass sich eine Durchlassspannung im Bereich von UF = 0.5 bis 0.6 Volt ergibt und gleichzeitig geringe Sperrströme auftreten und eine Barrierenhöhe (PhiBn) von 0.65 bis 0.75 Elektronenvolt gewählt wird, zum Einsatz der Gleichrichteranordnung für Generatoren, bei denen Temperaturen über 165°C auftreten können, jedoch unter 197°C bleiben.

2. Gleichrichteranordnung nach Anspruch 1, **dadurch gekennzeichnet, dass** die Gräben etwa 1-3 $\mu$m tief und etwa 0,5 bis 1 $\mu$m breit sind.

3. Gleichrichteranordnung nach Anspruch 2, **dadurch gekennzeichnet, dass** der Abstand der Gräben etwa 0.5 bis 1 $\mu$m beträgt.

4. Gleichrichteranordnung nach einem der vorhergehenden Ansprüche, **dadurch gekennzeichnet, dass** sie aus einem hochdotierten Substrat n+ (1) besteht sowie einer Epitaxieschicht (2), wenigstens zwei in der Epitaxieschicht (2) eingeätzte Gräben bzw. Trenches (6), dass eine Metallschicht (4) als Anoden-elektrode und eine Metallschichten (5) als Kathodenelektrode vorhanden sind, dass eine Oxidschicht (7) zwischen den Gräben (6) und der Metallschicht (4) liegt.

5. Gleichrichteranordnung nach Anspruch 4, **dadurch gekennzeichnet, dass** die Anordnung elektrisch als Kombination einer MOS-Struktur mit der Metallschicht (4), der Oxidschicht (7) und der n-Epischicht (2) und einer Schottky-Diode mit der Schottky-Barriere zwischen der Metallschicht (4) als Anode und der n-Epischicht (2) als Kathode wirkt.

6. Gleichrichteranordnung nach einem der vorhergehenden Ansprüche , **dadurch gekennzeichnet, dass** die Gleichrichterelemente direkt auf einem separaten Kühlkörper montiert sind.

7. Gleichrichteranordnung nach einem der vorhergehenden Ansprüche, **dadurch gekennzeichnet, dass** zu den HED-Elementen Standard-Zenerdioden parallel geschaltet sind, wodurch ein Load-Dump-Schutz erhalten wird.

**Claims**

1. Rectifier arrangement for a generator in a vehicle, with a semiconductor device, comprising a high-efficiency Schottky diode HED with a semiconductor chip, which has trench structures, with a combination of at least one Schottky diode with a further semiconductor element, said combination being mono-lithically integrated in the semiconductor chip, wherein the further semiconductor element is configured as a pn diode in the trench or as a MOS structure in the trench, **characterized in that** the forward voltage (UF) is set by choosing a barrier metal that defines the barrier height (PhiBn) for a Schottky barrier such that a forward voltage in the range of UF = 0.5 to 0.6 volt results and at the same time low reverse currents occur and a barrier height (PhiBn), of 0.65 to 0.75 electronvolt is chosen, for use of the rectifier arrangement for generators in which temperatures above 165°C can occur, but remain below 197°C.

2. Rectifier arrangement according to Claim 1, **characterized in that** the trenches have a depth of approximately 1-3 $\mu$m and a width of approximately 0.5 to 1 $\mu$m.

3. Rectifier arrangement according to Claim 2, **characterized in that** the distance between the trenches is approximately 0.5 to 1 $\mu$m.

4. Rectifier arrangement according to any of the preceding clams, **characterized in that** it consists of a highly doped substrate n+ (1) and also an epitaxial layer (2), at least two trenches (6) etched in the epitaxial layer (2), **in that** a metal layer (4) as anode electrode and a metal layer (5) as cathode electrode are present, **in that** an oxide layer (7) lies between the trenches (6) and the metal layer (4).

5. Rectifier arrangement according to Claim 4, **characterized in that** the arrangement acts electrically as a combination of a MOS structure with the metal layer (4), the oxide layer (7) and the n-type epitaxial layer (2) and a Schottky diode with the Schottky barrier between the metal layer (4) as anode and the n-type epitaxial layer (2) as cathode.

6. Rectifier arrangement according to any of the preceding claims, **characterized in that** the rectifier elements are mounted directly on a separate heat sink.

7. Rectifier arrangement according to any of the preceding claims, **characterized in that** standard zener diodes are connected in parallel with the HED elements, as a result of which load dump protection is obtained.

## Revendications

1. Système redresseur destiné à un générateur dans un véhicule automobile, comportant un dispositif à semi-conducteur, comprenant une diode Schottky à haut rendement HED ayant une puce à semi-conducteur présentant des structures de creux ou de tranchées munies d'une combinaison, intégrée de manière monolithique dans la puce à semi-conducteur, constituée d'au moins une diode Schottky avec un autre élément à semi-conducteur, dans lequel l'autre élément à semi-conducteur est réalisé sous la forme d'une diode PN dans la tranchée ou sous la forme d'une structure MOS dans la tranchée, **caractérisé en ce que** le réglage de la tension à l'état passant (UF) est effectué par sélection d'un métal de barrière qui définit la hauteur de barrière (PhiBn) pour une barrière Schottky, de manière à obtenir une tension à l'état passant se situant dans la plage de UF = 0,5 à 0,6 Volt et à ce que de faibles courants de blocage apparaissent simultanément, et **en ce qu'**une hauteur de barrière (PhiBn) de 0,65 à 0,75 électron-Volt est sélectionnée pour l'application du système redresseur à des générateurs dans lesquels des températures supérieures à 165°C peuvent apparaître, tout en restant inférieures à 197°C.

2. Système redresseur selon la revendication 1, **caractérisé en ce que** les tranchées ont une profondeur d'environ 1-3 $\mu$m et une largeur d'environ 0,5 à 1 $\mu$m.

3. Système redresseur selon la revendication 2, **caractérisé en ce que** l'espacement des tranchées est d'environ 0,5 à 1 $\mu$m.

4. Système redresseur selon l'une quelconque des revendications précédentes, **caractérisé en ce que** celui-ci est constitué d'un substrat fortement dopé de type n+ (1) ainsi que d'une couche épitaxiale (2), d'au moins deux creux ou tranchées (6) gravés dans la couche épitaxiale (2), **en ce qu'**une couche métallique (4) est prévue en tant qu'électrode d'anode et **en ce qu'**une couche métallique (5) est prévue en tant qu'électrode de cathode, et **en ce qu'**une couche d'oxyde (7) est située entre les tranchées (6) et la couche métallique (4).

5. Système redresseur selon la revendication 4, **caractérisé en ce que** le système fonctionne sous la forme d'une combinaison d'une structure MOS comportant la couche métallique (4), la couche d'oxyde (7) et la couche épitaxiale de type n (2) et d'une diode Schottky, la barrière Schottky étant située entre la couche métallique (4) en tant qu'anode et la couche épitaxiale de type n (2) en tant que cathode.

6. Système redresseur selon l'une quelconque des revendications précédentes, **caractérisé en ce que** les éléments redresseurs sont directement montés sur un corps de refroidissement séparé.

7. Système redresseur selon l'une quelconque des revendications précédentes, **caractérisé en ce que** des diodes Zenner standard sont connectées en parallèle aux éléments HED, cela conduisant à l'obtention d'une protection de surtension Load-Dump.

SBD / A = 26 mm$^2$

PhiBn = 0,7eV / IF = 100 A / UR = 14V

$$P = 0,5 * U_F * I_F + 0,5 * U_R * I_R$$

**Fig. 1**

**Fig. 2**

**Fig. 3a**

8

9

10

11

12

**Fig. 3b**

12

8

10

**Fig. 4a**

13 14 16 15

17

**Fig. 4b**

17 13 15

**Fig. 5**

18 19

20 21

22

**Fig. 6a**

**Fig. 6b**

**Fig. 6c**

## Fig. 7a

## Fig. 7a

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69428996 T2

- DE 19545234 A1

**In der Beschreibung aufgeführte Nicht-Patentliteratur**

- **VON B.J.BALIGA.** Power Semiconductor Devices. PWS Publishing Company, 1996